# EUROPEAN PATENT SPECIFICATION

(11) **EP 4 270 428 B1**
(45) Date of publication and mention of the grant of the patent: **18.11.2026**
(21) Application number: 22170542.9
(22) Date of filing: 28.04.2022
(51) Int. Cl.: H01G 2/02, H01G 2/04, H01G 2/06, H01G 2/10, H05K 3/30, H05K 5/00, H05K 7/12, H05K 3/34

(54) **MOUNTING STRUCTURE FOR A CAPACITOR**
MONTAGESTRUKTUR FÜR EINEN KONDENSATOR
STRUCTURE DE MONTAGE POUR UN CONDENSATEUR

(43) Date of publication of application: 01.11.2023
(73) Proprietor: Veoneer Sweden Safety Systems AB, 10302 Stockholm (SE)
(72) Inventor: SAVIN, Anatolie, 700051 Iasi (RO); CACU, Adrian, 700051 Iasi (RO)
(74) Representative: Mewburn Ellis LLP

(56) References cited:
- EP-A1- 3 982 384
- CN-U- 208 507 463
- DE-U1- 202010 017 072
- GB-A- 2 459 017
- US-A- 5 060 846
- US-A1- 2010 267 252
- US-A1- 2013 105 210
- US-A1- 2020 037 454

## Description

The invention relates to a mounting structure for a capacitor, in particular to a mounting structure where the capacitor is to be clamped between at least two holding elements. A possible use of the mounting structure is in electronic control units, for example electronic control units for vehicles.

Various electrical or electronic systems include capacitors among their components. Like other components of such a system, a capacitor has to be provided in the correct location within the system and correctly connected to other components of the system. It has to be assured, furthermore, that the capacitor also remains in the correct location. If the system is subject to vibration during use, a capacitor might become loose, which could cause the capacitor to rattle and thus be a source of noise. Worse even, connections between the capacitor and other components could be compromised or interrupted. It is also conceivable that during movements of the capacitor the capacitor or other components of the system suffer damage.

In order to avoid the above problems, the prior art considers holding the capacitor in place by at least one pair, often by two pairs, of elastic holding elements which protrude from a basis. The capacitor is in contact with the basis and the elastic holding elements exert a force on the capacitor to hold it in place. The elastic force exerted on the capacitor by the holding elements may not always be enough to keep the capacitor in its desired location. Heavy capacitors require correspondingly strong forces to be exerted by the holding elements in order to remain secured in place. The force exerted by the holding elements on the capacitor is adversely affected by manufacturing tolerances of the holding elements but especially also by manufacturing tolerances of the capacitor. For the holding elements to exert an elastic force on the capacitor, the holding elements need to be deformed with respect to their strain-free position. This deformation is done by the capacitor and depends on the size, more precisely the diameter of the capacitor. If, for example due to tolerances, the diameter of the capacitor is too small, the elastic deformation of the holding elements will be too small and the force arising therefrom will be too weak to secure the capacitor. If the diameter of the capacitor is too large, the capacitor may not fit properly between the holding elements, and furthermore the holding elements might suffer plastic (i.e. permanent) deformations, creep, or even fractures.

US patent application US 2013 / 0 105 210 A1 discloses a capacitor laterally contained in a lower holder, to be pressed on by an upper holder, which contains pressing elements.

German utility model DE 20 2010 017 072 U1 discloses a capacitor received into a suitably shaped basis and pressed towards the basis by an element that can be fixed to the basis.

Utility model CN 208507463 U discloses an elastic ring for receiving a capacitor. The ring has a base for fixing the ring in a larger system.

US patent application US 2020 / 0 037 454 A1 discloses a device to be connected to a printed circuit board in order to provide added structural rigidity to a capacitor mounted on the printed circuit board. The device is designed to exert a force on the capacitor towards the printed circuit board.

European patent application EP 3 982 384 A1 discloses an electronic control unit for a vehicle. The electronic control unit has a mounting structure for capacitor, for example a cradle. The electronic control unit also has a connector body for electrically connecting a printed circuit board to an environment of the electronic control unit.

It is an object of the invention to provide a mounting structure for a capacitor which provides a more reliable securing of the capacitor in place.

This object is achieved by a mounting structure according to claim 1 or claim 4. Claim 9 relates to a corresponding electronic control unit and claim 12 to a corresponding vehicle.

The inventive mounting structure for a capacitor has at least one pair of elastic holding elements located on a basis and arranged to receive the capacitor between the elastic holding elements. According to the invention, additionally an elastic tab is provided for holding the capacitor. The elastic tab is located such that the capacitor is to be received between the elastic tab and the basis, the tab arranged to exert a force on the capacitor towards the basis.

Basis and tab secure the capacitor against movement along a first axis, the first axis running from the tab to the basis. Each pair of elastic holding elements secures the capacitor against movement along a respective second axis running between the holding elements of the given pair and perpendicular to the first axis. If there is more than one pair of elastic holding elements, all the respective second axes are parallel. Each pair of elastic holding elements may also secure the capacitor against movement along the first axis by a clamping force and / or a friction force. Along a third axis, perpendicular to both the first and the second axis, the capacitor is secured by friction on the elastic holding elements, the friction force arising due to the elastic force the holding elements exert on the capacitor. A further friction force, securing the capacitor along the third axis arises from the elastic force the elastic tab exerts on the capacitor. Capacitor and basis may, as in prior art, have structures like ridges and notches further securing the capacitor along the third axis. In comparison with prior art the mounting structure according to the invention provides for a more reliable securing of the capacitor due to the additional friction from the tab and due to the tab exerting a force on the capacitor towards the basis. This latter force prevents the capacitor from moving away from the basis along the first axis; in prior art this movement is only prevented by a clamping force and / or a friction force exerted on the capacitor by the holding elements.

In one alternative of the invention, the tab is connected to a connector body. In another alternative of the invention, the tab is connected to a pin alignment plate.

The basis with the holding elements in application cases forms part of a larger system, the system having additional components, like a connector body or a pin alignment plate. The tab is connected to either a connector body or a pin alignment plate. In one embodiment, the tab and the connector body or pin alignment plate, respectively, are of the same material and form one integral part. The tab and the connector body or pin alignment plate, respectively, may for example be formed by injection moulding. In different embodiments of the invention, the tab may be manufactured as a separate part and attached to the connector body or pin alignment plate, respectively, with suitable means, like for instance screws, snaps, crush ribs.

A connector body is configured to hold at least one electrically conductive pin and an electric connection of this at least one pin to an environment of the mounting structure. Connector bodies are part of many electric or electronic systems. In such systems, provided they also have a basis with holding elements as discussed above, the invention can be easily implemented by arranging the tab on the connector body, as long as the general arrangement of basis and connector body in the system is such that the tab can function according to the invention. In the production of the connector body only a minor change, the tab, needs to be introduced. No separate support structures for the tab are required.

A pin alignment plate is configured to define the position of at least one electrically conducting pin. Pin alignment plates as such are known in the art. As with the previously described alternative of the invention, the tab is arranged on an already known part. No separate support structures for the tab are required. Manufacture of the pin alignment plate requires only a minor alteration.

In an embodiment of the mounting structure the holding elements are of the same material as the basis and form one integral part with the basis. Basis and holding elements may for example be formed by injection moulding. This provides for easy manufacturing of the basis with the holding elements.

By shaping the tab, the elastic properties of the tab may be adapted to the specific use case. To this end, in an embodiment, a portion of the tab adjacent to the connector body or pin alignment plate, respectively, is provided with a stiffening structure. This implies that the portion of the tab adjacent to the connector body or pin alignment plate is stiffer, in many cases considerably stiffer, than the portion of the tab more distant from the component the tab is arranged on, which latter portion is intended to be in contact with the capacitor.

In an embodiment the tab has a shape adapted to the capacitor. In particular, the tab may have angled portions and / or a contour for better contact with the capacitor and an even more reliable securing of the capacitor. The contour may be adapted to the shape of the capacitor and thus lead to a larger contact surface between the capacitor and the tab. Angled portions contribute to the securing of the capacitor by restricting movement of the capacitor, for example in a hook-like fashion.

An electronic control unit may include a capacitor for various reasons. A typical role of a capacitor in an electronic control unit is as a backup power supply or emergency power supply in case the main power supply, for example a rechargeable battery, fails. An electronic control unit according to the invention has a mounting structure as described above. As such a mounting structure secures a capacitor more reliably than prior art approaches, an electronic control unit according to the invention has a lower probability of failure and of emitting noise due to loose parts than a prior art electronic control unit.

In an embodiment, the electronic control unit has two groups of pins (shrouds of pins) connected to an environment of the electronic control unit via a connector body. The tab is arranged between the two groups of pins on the connector body. This arrangement does not require any modification to the placement and connection of the pins. In different embodiments, the tab may be located elsewhere on the connector body.

In an alternative embodiment, the electronic control unit has two groups of pins (shrouds of pins) aligned by a pin alignment plate. The tab is arranged between the two groups of pins on the pin alignment plate. This arrangement does not require any modification to the placement and connection of the pins. In different embodiments, the tab may be located elsewhere on the pin alignment plate.

An electronic control unit may have both a connector body and a pin alignment plate as in the embodiments just discussed. In such a case, the tab may be provided either on the connector body or on the pin alignment plate.

A vehicle according to the invention has at least one electronic control unit according to the invention, as described above. As an electronic control unit according to the invention has a lower probability of failure, the electronic control units according to the invention in such a vehicle will perform their functions more reliably, and in this way contribute to a more reliable operation of the vehicle. Avoiding of loose parts in an electronic control unit avoids noise which could be annoying to passengers and drivers, and also a potentially dangerous distraction.

Below, the invention and its advantages will be discussed in further detail with reference to the accompanying figures.
- Figure 1: shows a prior art mounting structure.
- Figure 2: shows a section of the prior art mounting structure of Fig. 1 holding a capacitor.
- Figure 3: shows a mounting structure according to the invention.
- Figure 4: shows the tab arranged on a connector body.
- Figure 5: shows the tab arranged on a connector body.
- Figure 6: shows a mounting structure according to the invention.
- Figure 7: shows a capacitor secured by a tab.
- Figure 8: shows a capacitor secured by a tab.
- Figure 9: shows part of a connector body.
- Figure 10: shows a vehicle with an electronic control unit according to the invention.

The figures show only examples illustrating how the invention can be implemented. The figures and their corresponding description are therefore not to be considered a restriction of the invention to the specific examples shown.

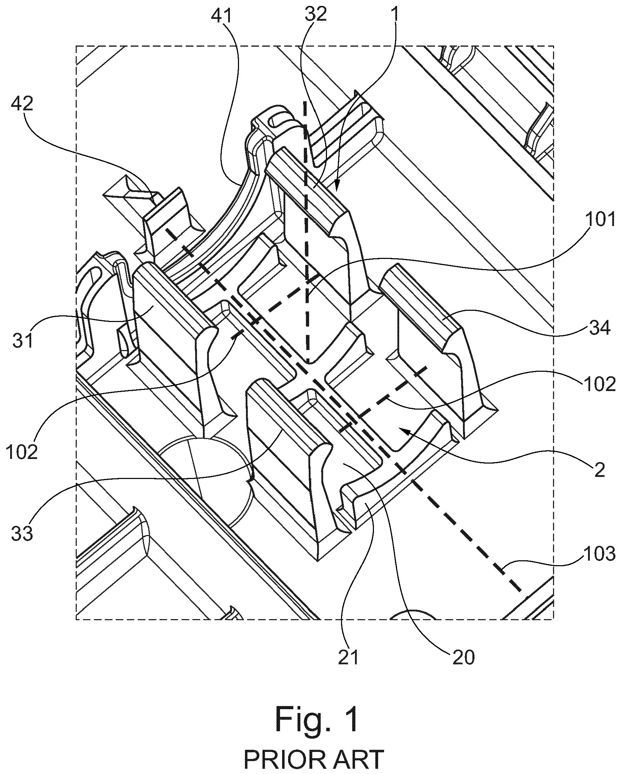

**Fig. 1** shows a prior art mounting structure 1 with a basis 2 from which protrude two pairs of holding elements, a first pair of holding elements 31, 32 and a second pair of holding elements 33, 34. The basis 2 has support structures 21 for a capacitor on a basis plane 20. The mounting structure 1 furthermore has a ridge 41 and a stop block 42. The mounting structure shown here is one integral part, formed by injection moulding.

Shown is a first axis 101, perpendicular to the basis plane 20. Shown is a respective second axis 102 for the first pair of holding elements 31, 32 and for the second pair of holding elements 33, 34; the second axis 102 of each pair of holding elements is running between the holding elements of the respective pair. The two second axes 102 shown are parallel to each other and orthogonal to the first axis 101. Shown is a third axis 103, which is perpendicular to the first axis 101 and each of the second axes 102.

The mounting structure 1 is also known as a cradle. The inventive mounting structure includes a cradle like or similar to the one shown in Fig. 1. In particular, the definition of the axes 101, 102, and 103 also applies to the mounting structure according to the invention.

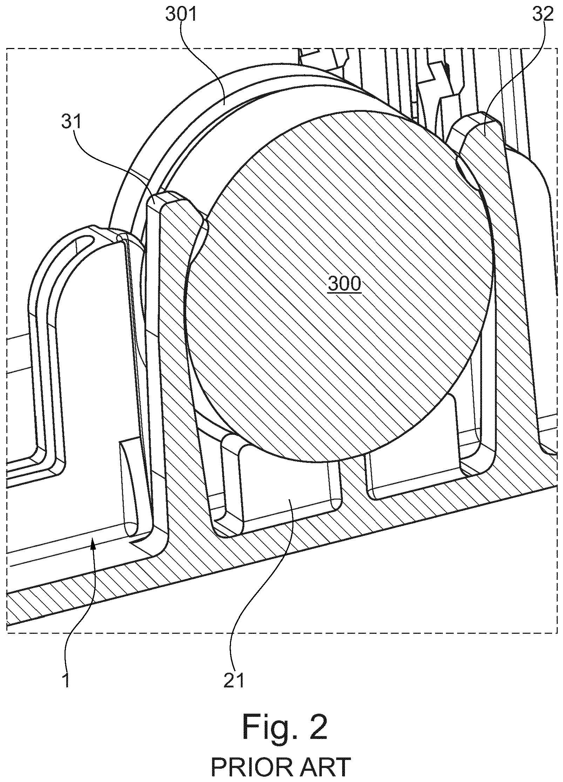

**Fig. 2** shows a section through the mounting structure of Fig. 1, into which a capacitor 300 is inserted. The plane of section is perpendicular to the third axis 103 (see Fig. 1) and runs through the first pair of holding elements 31, 32. The capacitor 300 has a circumferential notch 301 to engage ridge 41 (see Fig. 1) for securing against movement along the third axis 103. The holding elements 31 and 32 engage the capacitor 300 to secure the capacitor 300 in place by clamping and / or friction forces. Shown is also a part of the support structure 21. The stop block 42 (see Fig. 1) also contributes to the securing of the capacitor 300.

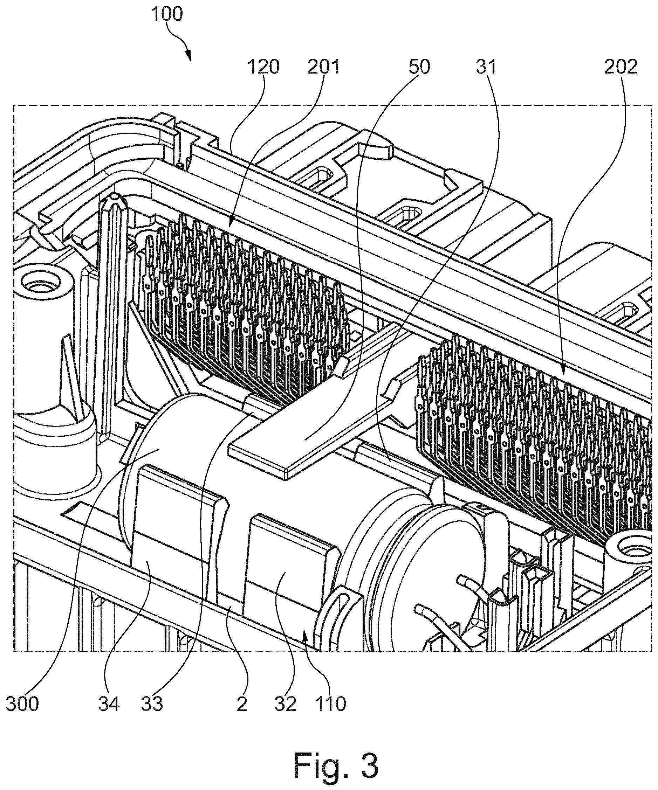

**Fig. 3** shows a mounting structure 100 according to the invention. The mounting structure 100 according to the invention includes a cradle 110 as shown in Fig. 1, with a first pair of holding elements 31, 32 and a second pair of holding elements 33, 34. In the figure, a capacitor 300 is shown inserted between the holding elements 31, 32, 33, 34. The inventive mounting structure 100 has a tab 50, and the capacitor 300 is located between the tab 50 and the basis 2 of the cradle 110 from which basis 2 the holding elements 31, 32, 33, 34 protrude. The tab 50 exerts a force on the capacitor 300 towards the basis 2, along the first axis 101 (see Fig. 1), and thus secures the capacitor 300 against movement along the first axis 101. Friction between the tab 50 and the capacitor 300 additionally secures the capacitor 300 with respect to motion along the third axis 103 (see Fig. 1). In the example shown the tab 50 is arranged on a connector body 120, which holds two groups of electrically conductive pins, 201 and 202. The tab 50 is arranged between the two groups of pins 201 and 202. In the example shown the tab 50 and the connector body 120 are of the same material and form one integral part.

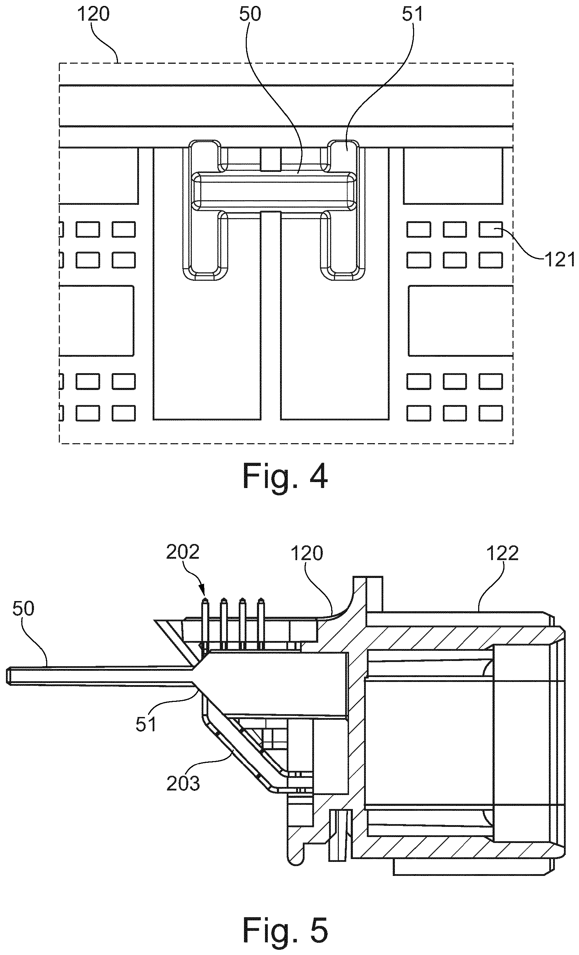

**Fig. 4** shows the tab 50 arranged on connector body 120 also shown in Fig. 3. The view is along the tab 50 towards the connector body 120. The tab 50 has a stiffening structure 51 at the portion of the tab 50 adjacent to the connector body 120. Further shown are openings 121 in the connector body 120, which are provided for passing an electrical connection, like a wire, from a pin held by the connector body 120 to an environment of the connector body 120.

**Fig. 5** shows the tab 50 arranged on connector body 120 also shown in Fig. 3. The tab 50 has a stiffening structure 51 at a portion of the tab 50 adjacent to the connector body 120. Shown is also a group of pins 202 held by the connector body 120 and wires 203 for providing an electrical connection of these pins to an environment. To this end, portion 122 of the connector body 120 serves as a plug. The wires 203 are passed through openings 121 shown in Fig. 4.

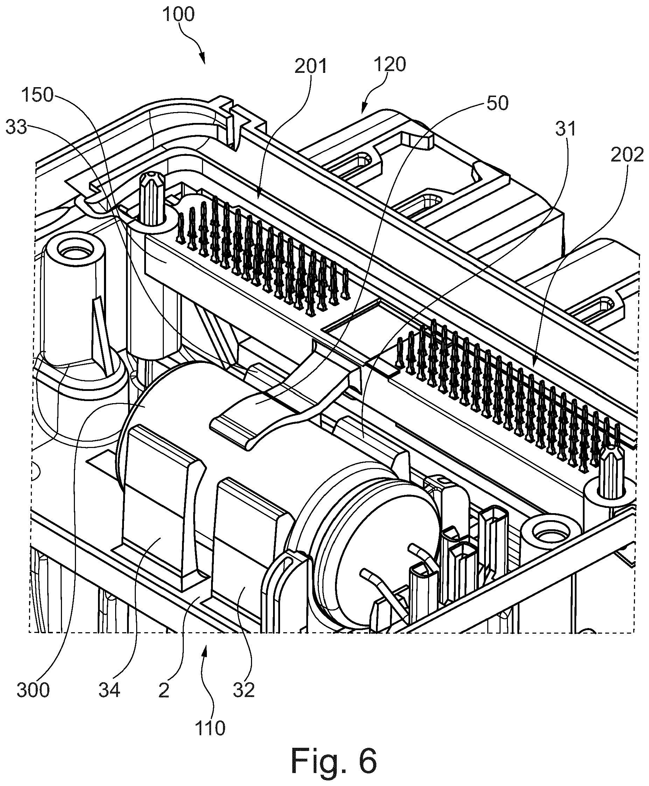

**Fig. 6** shows a mounting structure 100 according to the invention. The mounting structure 100 according to the invention includes a cradle 110 as shown in Fig. 1, with a first pair of holding elements 31, 32 and a second pair of holding elements 33, 34. In the figure, a capacitor 300 is shown inserted between the holding elements 31, 32, 33, 34. The inventive mounting structure 100 has a tab 50, and the capacitor 300 is located between the tab 50 and the basis 2 of the cradle 110 from which the holding elements 31, 32, 33, 34 protrude. The tab 50 exerts a force on the capacitor 300 towards the basis 2, along the first axis 101 (see Fig. 1), and thus secures the capacitor 300 against movement along the first axis 101. Friction between the tab 50 and the capacitor 300 additionally secures the capacitor 300 with respect to motion along the third axis 103 (see Fig. 1). In the example shown the tab 50 is arranged on a pin alignment plate 150, which aligns two groups of electrically conductive pins, 201 and 202. The tab 50 is arranged between the two groups of pins 201 and 202. In the example shown the tab 50 and the pin alignment plate 150 are of the same material and form one integral part. The arrangement shown in Fig. 6 has a connector body 120 in addition to the pin alignment plate 150. The tab 50 has a contour adapted to a surface of the capacitor 300; this results in a larger contact area between the tab 50 and the capacitor 300 compared with the case of the straight tab of Fig. 3.

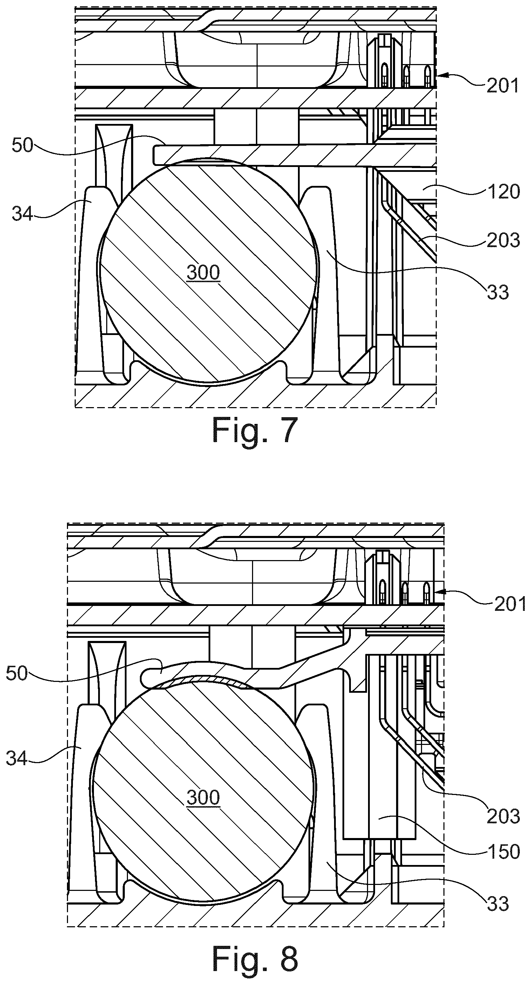

**Fig. 7** shows a capacitor 300 secured by a tab 50 in a sectional view. The plane of section is perpendicular to the third axis 103 (see Fig. 1) and runs through the tab 50. Shown are furthermore holding elements 33 and 34, a connector body 120, on which the tab 50 is arranged, and wires 203 for connecting pins 201 to an environment. As can be seen, the tab 50 does not occupy much space. There is sufficient space for further components in the area limited by the capacitor 300, tab 50, and connector body 120.

**Fig. 8** shows a capacitor 300 secured by a tab 50 in a sectional view. The plane of section is perpendicular to the third axis 103 (see Fig. 1) and runs through the tab 50. Shown are furthermore holding elements 33 and 34, a pin alignment plate 150, on which the tab 50 is arranged, and wires 203 for connecting pins 201 to an environment. As can be seen, the tab 50 does not occupy much space. There is sufficient space for further components in the area limited by the capacitor 300, tab 50, and pin alignment plate 150. The tab 50 has a contour adapted to a surface of the capacitor 300, leading to an increased contact area between the tab 50 and the capacitor 300, compared with the case of the straight tab shown in Fig. 7.

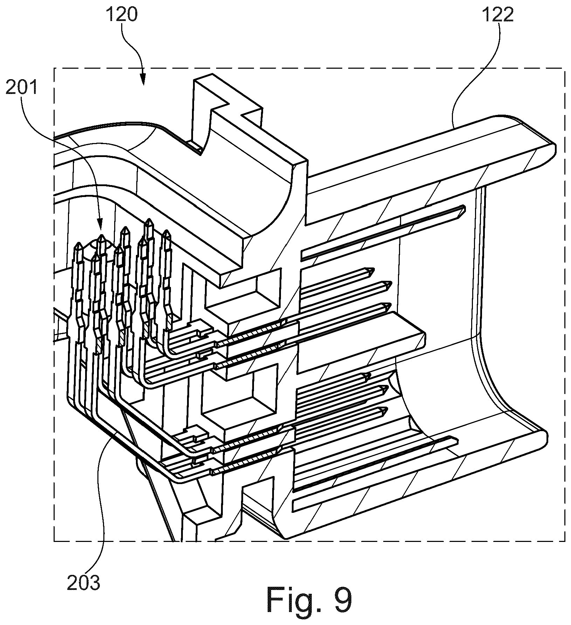

**Fig. 9** shows part of a connector body 120, including portion 122 serving as a plug, in a section view. Shown are pins 201 and wires 203 connecting pins 201 to an environment. In the example shown, each pin and its corresponding wire, providing the connection of the respective pin to the environment, are one integral piece of metal, adequately shaped and bent to provide the pin structure and the connection to the environment.

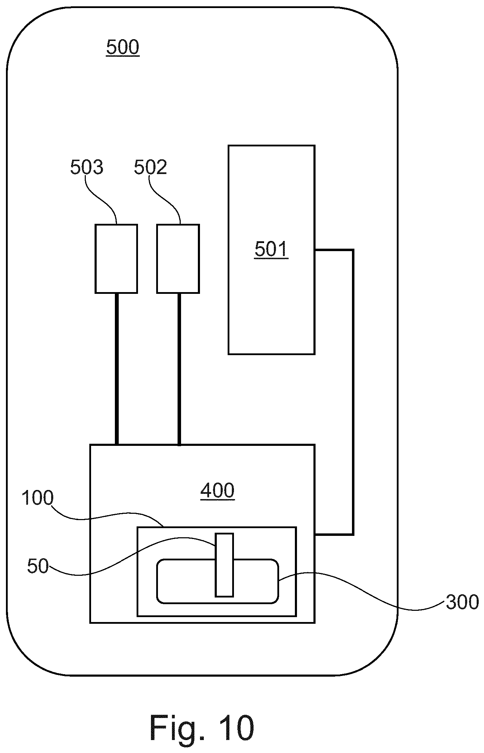

**Fig. 10** shows a vehicle 500 according to the invention having an electronic control unit 400 according to the invention. The electronic control unit 400 is provided for controlling subsystems 502 and 503 of the vehicle 500. A rechargeable battery 501 is the main power supply for the electronic control unit 400. The electronic control unit 400 includes a mounting structure 100 according to the invention, which is only shown schematically and of which only the tab 50 is schematically indicated as engaging a capacitor 300 in the electronic control unit 400. In the example shown the capacitor 300 serves as emergency power supply for the electronic control unit 400 in case the rechargeable battery 501 fails. As an emergency power supply the capacitor 300 is of relatively large dimension and mass, but due to the inventive mounting structure 100 can nonetheless be reliably secured in its desired location.

### List of Reference Signs

- 1: mounting structure
- 2: basis
- 20: basis plane
- 21: support structure
- 31: holding element
- 32: holding element
- 33: holding element
- 34: holding element
- 41: ridge
- 42: stop block
- 50: tab
- 51: stiffening structure (of tab)
- 100: mounting structure
- 101: first axis
- 102: second axis
- 103: third axis
- 110: cradle
- 120: connector body
- 121: openings (in connector body)
- 122: portion (of connector body)
- 150: pin alignment plate
- 201: group of pins
- 202: group of pins
- 203: wire
- 300: capacitor
- 301: notch
- 400: electronic control unit
- 500: vehicle
- 501: rechargeable battery
- 502: subsystem (of vehicle)
- 503: subsystem (of vehicle)

## Claims

1. Mounting structure (100) for a capacitor (300), the mounting structure (100) comprising
at least one pair of elastic holding elements (31, 32, 33, 34) located on a basis (2) and arranged to receive the capacitor (300) between the elastic holding elements (31, 32, 33, 34),
**characterised by**
an elastic tab (50) located such that the capacitor (300) is to be received between the elastic tab (50) and the basis (2), the tab (50) arranged to exert a force on the capacitor (300) towards the basis (2), the tab connected to a connector body (120) configured to hold at least one electrically conductive pin (201, 202) and an electric connection (203) of this at least one pin (201, 202) to an environment of the mounting structure (100).

2. Mounting structure (100) according to claim 1, wherein the tab (50) and the connector body (120) are of the same material and form one integral part.

3. Mounting structure (100) according to claim 1 or 2, wherein a portion of the tab adjacent to the connector body (120) is provided with a stiffening structure (51).

4. Mounting structure (100) for a capacitor (300), the mounting structure (100) comprising
at least one pair of elastic holding elements (31, 32, 33, 34) located on a basis (2) and arranged to receive the capacitor (300) between the elastic holding elements (31, 32, 33, 34),
**characterised by**
an elastic tab (50) located such that the capacitor (300) is to be received between the elastic tab (50) and the basis (2), the tab (50) arranged to exert a force on the capacitor (300) towards the basis (2), the tab connected to a pin alignment plate (150) configured to define the position of at least one electrically conductive pin (201, 202).

5. Mounting structure (100) according to claim 4, wherein the tab (50) and the pin alignment plate (150) are of the same material and form one integral part.

6. Mounting structure (100) according to claim 4 or 5, wherein a portion of the tab adjacent to the pin alignment plate (150) is provided with a stiffening structure (51).

7. Mounting structure (100) according to one of the previous claims, wherein the holding elements (31, 32, 33, 34) are of the same material as the basis (2) and form one integral part with the basis (2).

8. Mounting structure (100) according to one of the previous claims, wherein the tab (50) has a shape adapted to the capacitor (300).

9. Electronic control unit (400)
**characterised by** comprising
a mounting structure (100) according to one of the claims 1 to 8.

10. Electronic control unit (400) according to claim 9 with two groups of electrically conductive pins (201, 202) connected to an environment of the electronic control unit (400) via a connector body (120), wherein the tab (50) is arranged between the two groups of pins (201, 202) on the connector body (120).

11. Electronic control unit (400) according to claim 9 with two groups of electrically conductive pins (201, 202) aligned by a pin alignment plate (150), wherein the tab (50) is arranged between the two groups of pins (201, 202) on the pin alignment plate (150).

12. Vehicle (500)
**characterised by**
an electronic control unit (400) according to one of the claims 9 to 11.

## Patentansprüche

1. Montagestruktur (100) für einen Kondensator (300), wobei die Montagestruktur (100) Folgendes umfasst:
zumindest ein Paar von elastischen Halteelementen (31, 32, 33, 34), die auf einer Basis (2) angeordnet sind und dazu angeordnet sind, den Kondensator (300) zwischen den elastischen Halteelementen (31, 32, 33, 34) aufzunehmen.
**gekennzeichnet durch**
eine elastische Lasche (50), die derart angeordnet ist, dass der Kondensator (300) zwischen der elastischen Lasche (50) und der Basis (2) aufzunehmen ist, wobei die Lasche (50) angeordnet ist, um eine Kraft auf den Kondensator (300) in Richtung der Basis (2) auszuüben, wobei die Lasche mit einem Verbinderkörper (120) verbunden ist, der dazu ausgelegt ist, zumindest einen elektrisch leitfähigen Stift (201, 202) und eine elektrische Verbindung (203) des zumindest einen Stifts (201, 202) an einer Umgebung der Montagestruktur (100) zu halten.

2. Montagestruktur (100) nach Anspruch 1, wobei die Lasche (50) und der Verbinderkörper (120) aus dem gleichen Material bestehen und einen einstückig ausgebildeten Teil ausbilden.

3. Montagestruktur (100) nach Anspruch 1 oder 2, wobei ein Abschnitt der Lasche benachbart zu dem Verbinderkörper (120) mit einer Versteifungsstruktur (51) bereitgestellt ist.

4. Montagestruktur (100) für einen Kondensator (300), wobei die Montagestruktur (100) Folgendes umfasst:
zumindest ein Paar von elastischen Halteelementen (31, 32, 33, 34), die auf einer Basis (2) angeordnet sind und dazu angeordnet sind, den Kondensator (300) zwischen den elastischen Halteelementen (31, 32, 33, 34) aufzunehmen,
**gekennzeichnet durch**:
eine elastische Lasche (50), die derart angeordnet ist, dass der Kondensator (300) zwischen der elastischen Lasche (50) und der Basis (2) aufzunehmen ist, wobei die Lasche (50) angeordnet ist, um eine Kraft auf den Kondensator (300) in Richtung der Basis (2) auszuüben, wobei die Lasche mit einer Stiftausrichtungsplatte (150) verbunden und dazu ausgelegt ist, die Position von zumindest einem elektrisch leitfähigen Stift (201, 202) zu definieren.

5. Montagestruktur (100) nach Anspruch 4, wobei die Lasche (50) und die Stiftausrichtungsplatte (150) aus dem gleichen Material bestehen und einen einstückig ausgebildeten Teil ausbilden.

6. Montagestruktur (100) nach Anspruch 4 oder 5, wobei ein Abschnitt der Lasche benachbart zur Stiftanordnungsplatte (150) mit einer Versteifungsstruktur (51) bereitgestellt ist.

7. Montagestruktur (100) nach einem der vorangegangenen Ansprüche, wobei die Halteelemente (31, 32, 33, 34) aus dem gleichen Material bestehen wie die Basis (2) und mit der Basis (2) einen einstückig ausgebildeten Teil ausbilden.

8. Montagestruktur (100) nach einem der vorangegangenen Ansprüche, wobei die Lasche (50) eine Form aufweist, die an den Kondensator (300) angepasst ist.

9. Elektrische Steuereinheit (400),
**dadurch gekennzeichnet, dass** sie eine Montagestruktur (100) nach einem der Ansprüche 1 bis 8 umfasst.

10. Elektrische Steuereinheit (400) nach Anspruch 9 mit zwei Gruppen von elektrisch leitfähigen Stiften (201, 202), die mit einer Umgebung der elektronischen Steuereinheit (400) über einen Verbinderkörper (120) verbunden sind, wobei die Lasche (50) zwischen den zwei Gruppen von Stiften (201, 202) auf dem Verbinderkörper (120) angeordnet ist.

11. Elektronische Steuereinheit (400) nach Anspruch 9 mit zwei Gruppen von elektrisch leitfähigen Stiften (201, 202), die durch eine Stiftausrichtungsplatte (150) fluchtend ausgerichtet sind, wobei die Lasche (50) zwischen zwei Gruppen von Stiften (201, 202) auf der Stiftanordnungsplatte (150) angeordnet ist.

12. Fahrzeug (500),
**gekennzeichnet durch**
eine elektronische Steuereinheit (400) nach einem der Ansprüche 9 bis 11.

## Revendications

1. Structure de montage (100) pour un condensateur (300), la structure de montage (100) comprenant
au moins une paire d'éléments de retenue élastiques (31, 32, 33, 34) situés sur une base (2) et agencés pour recevoir le condensateur (300) entre les éléments de retenue élastiques (31, 32, 33, 34),
**caractérisée par**
une patte élastique (50) située de telle sorte que le condensateur (300) soit reçu entre la patte élastique (50) et la base (2), la patte (50) étant agencée pour exercer une force sur le condensateur (300) vers la base (2), la patte étant connectée à un corps de connecteur (120) configuré pour retenir au moins une broche électriquement conductrice (201, 202) et une connexion électrique (203) de cette au moins une broche (201, 202) à un environnement de la structure de montage (100).

2. Structure de montage (100) selon la revendication 1, dans laquelle la patte (50) et le corps de connecteur (120) sont du même matériau et forment une pièce d'un seul tenant.

3. Structure de montage (100) selon la revendication 1 ou 2, dans laquelle une partie de la patte adjacente au corps de connecteur (120) est pourvue d'une structure de raidissement (51).

4. Structure de montage (100) pour un condensateur (300), la structure de montage (100) comprenant
au moins une paire d'éléments de retenue élastiques (31, 32, 33, 34) situés sur une base (2) et agencés pour recevoir le condensateur (300) entre les éléments de retenue élastiques (31, 32, 33, 34),
**caractérisée par**
une patte élastique (50) située de telle sorte que le condensateur (300) soit reçu entre la patte élastique (50) et la base (2), la patte (50) étant agencée pour exercer une force sur le condensateur (300) vers la base (2), la patte étant connectée à une plaque d'alignement de broches (150) configurée pour définir la position d'au moins une broche électriquement conductrice (201, 202).

5. Structure de montage (100) selon la revendication 4, dans laquelle la patte (50) et la plaque d'alignement de broches (150) sont du même matériau et forment une pièce d'un seul tenant.

6. Structure de montage (100) selon la revendication 4 ou 5, dans laquelle une partie de la patte adjacente à la plaque d'alignement de broches (150) est pourvue d'une structure de raidissement (51).

7. Structure de montage (100) selon l'une quelconque des revendications précédentes, dans laquelle les éléments de retenue (31, 32, 33, 34) sont du même matériau que la base (2) et font partie intégrante de la base (2).

8. Structure de montage (100) selon l'une des revendications précédentes, dans laquelle la patte (50) présente une forme adaptée au condensateur (300).

9. Unité de commande électronique (400) **caractérisée en ce qu'**elle comprend
une structure de montage (100) selon l'une quelconque des revendications1 à 8.

10. Unité de commande électronique (400) selon la revendication 9, avec deux groupes de broches électriquement conductrices (201, 202) connectées à un environnement de l'unité de commande électronique (400) via un corps de connecteur (120), dans laquelle la patte (50) est agencée entre les deux groupes de broches (201, 202) sur le corps de connecteur (120).

11. Unité de commande électronique (400) selon la revendication 9, avec deux groupes de broches électriquement conductrices (201, 202) alignées par une plaque d'alignement de broches (150), dans laquelle la patte (50) est agencée entre les deux groupes de broches (201, 202) sur la plaque d'alignement de broches (150).

12. Véhicule (500)
**caractérisé par**
une unité de commande électronique (400) selon l'une quelconque des revendications 9 à 11.
